# EUROPEAN PATENT APPLICATION

(11) **EP 2 717 248 A1**
(43) Date of publication of application: **09.04.2014**
(21) Application number: 13275245.2
(22) Date of filing: 04.10.2013
(51) Int. Cl.: G09G 3/00, G02F 1/13, G09G 3/34

(54) **Electronic paper panel and electronic shelf lavel system and method for driving thereof**

(30) Priority: 05.10.2012 KR 20120110680
(71) Applicant: Samsung Electro-Mechanics Co., Ltd., Gyeonggi-do (KR)
(72) Inventor: Moon, Ung Han, Gyeonggi-do 443-743 (KR); Lee, Jae Shin, Gyeonggi-do 443-743 (KR); Park, Sung Il, Gyeonggi-do 443-743 (KR)
(74) Representative: Powell, Timothy John

(57) **Abstract**

The present invention relates to an electronic paper panel, an electronic shelf label system and a method for driving the same. The electronic paper panel includes a substrate formed thereon a wiring pattern and a damage sensing pattern, an insulating layer formed on the wiring pattern, a segment electrode formed on the insulating layer and electrically connected to the wiring pattern and a driving chip mounted on the substrate.

## Description

### CROSS-REFERENCE TO RELATED APPLICATIONS

Claim and incorporate by reference domestic priority application and foreign priority application as follows:
"CROSS REFERENCE TO RELATED APPLICATION
   This application claims the benefit of Korean Patent Application Serial No. 10-2012-0110680, entitled filed October 5, 2012, which is hereby incorporated by reference in its entirety into this application."

### BACKGROUND OF THE INVENTION

### 1. Field of the Invention

The present invention relates to an electronic paper panel, an electronic shelf label system and a method for driving thereof; and, more particularly, to an electronic paper panel capable of the damage of the electronic paper panel rapidly, an electronic shelf label system and a method for driving thereof.

### 2. Description of the Related Art

In general, a label for displaying the information of goods and a price is used for displaying and sailing a lot of goods in a specific space such as various distribution markets.

Such electronic shelf label has been used in a method of being attached to a portion where the corresponding goods are displayed by printing the information of goods on a paper, for example, directly handwriting the price and discount information on the paper or displaying these, required to sale on a paper according to a standard format. However, when the price changes of some articles are generated among ten thousands of product articles, these are selected and the corresponding labels are corrected and changed with picking up the place where the corresponding goods are displayed in the selling store, after the information of goods such as the changed price or the like are handwritten or printed. Accordingly, such works need to require the time of exchange and manpower every time the price information of goods is changed; and, therefore, there are needs to improve this problem in nature of a large distributor and to develop a method capable of exchanging the product information rapidly, correctly and easily with only a minimum additional cost.

In recent, based on the requirements of such markets, the trial to replace a conventional paper label with an electronic tag has been under way.

If the update information of goods is wirelessly transmitted in a wire/wireless converting device according to the request of a central server, the electronic tag receives it to display. Accordingly, since the central server the electronic tags for all products, the effective management is allowable.

Meanwhile, since the electronic tag displays the price or the information of goods by using a battery in its nature of structure, in order to expand the service life of battery, the electronic tag having an electronic paper has been widely used for improving the efficiency of energy by reducing the energy consumption by allowing once displayed contents to be maintained continuously without applying the power and applying the power only when the displayed contents are changed.

However, the electronic tag adopting the electronic paper performs the communication with the central server normally when the electronic paper panel to display is damaged; and, although the changed information of goods is transmitted, the contents to be changed due to the damage of the electronic paper panel are not displayed. Accordingly, there is a problem that the manager cannot discriminate the damaged status of the electronic paper panel.

### SUMMARY OF THE INVENTION

The present invention has been invented in order to overcome the above-described problems and it is, therefore, an object of the present invention to provide an electronic paper panel capable of discriminating the damaged status of an electronic tag, an electronic shelf label system and a method for driving thereof.

In accordance with a first embodiment of the present invention to achieve the object, there is provided an electronic paper panel including a substrate formed thereon a wiring pattern and a damage sensing pattern, an insulating layer formed on the wiring pattern, a segment electrode formed on the insulating layer and electrically connected to the wiring pattern and a driving chip mounted on the substrate.

Herein, the electronic paper panel further includes an electronic paper film formed on the segment electrode.

At this time, the electronic paper film includes an electronic paper layer, a common electrode formed on the electronic paper layer and a protection layer formed on the common electrode.

And also, a voltage is applied to the damage sensing pattern.

In addition, the electronic paper panel further includes a sensing unit to sense the voltage to be applied by being electrically connected to the damage sensing pattern.

In accordance with a second embodiment of the present invention to achieve the object, there is provided an electronic shelf label system including an electronic tag installed on a display stand for transmitting a damage generation signal when an electronic paper panel is damaged, a server for generating a repair request signal when the damage generation signal is generated and a wire/wireless communication converting unit for relaying information between the electronic tag and the server and for transmitting the damage generation signal received from the electronic tag which is in charge of the relay to the server.

Herein, the electronic tag includes an electronic paper panel provided with a damage sensing pattern and a sensor unit for sensing a voltage of the damage sensing pattern and a processor unit for transmitting the damage generation signal to a wire/wireless communication converting unit according to the sensing result of a sensor unit.

At this time, the sensor unit senses the voltage of the damage sensing pattern formed on the electronic paper panel and transmitting the damage generation signal to the processor unit if the voltage is not sensed.

In accordance with a third embodiment of the present invention to achieve the object, there is provided a method for driving an electronic shelf label system which includes inspecting a damage of an electronic tag including a damage sensing pattern, a sensor unit and a processor unit and generating a damage generating signal when the damage is generated, transmitting the generated damage generation signal to a wire/wireless communication converting unit, delivering the damage generation signal received from the wire/wireless communication converting unit to a server and generating a repair request signal when the damage generation signal is received to the server.

Herein, transmitting the damage generation signal when the damage of the electronic tag including the damage sensing pattern, a sensor unit and a processor unit is generated includes applying a voltage to the damage sensing pattern and measuring the voltage applied to the damage sensing pattern with the sensor unit and transmitting the damage generation signal to the processor unit if the voltage is not measured.

And also, in transmitting the generated damage generation signal to a wire/wireless communication converting unit, the damage generation signal is transmitted to the wire/wireless communication converting unit from a processor unit of the electronic tag.

### BRIEF DESCRIPTION OF THE DRAWINGS

These and/or other aspects and advantages of the present general inventive concept will become apparent and more readily appreciated from the following description of the embodiments, taken in conjunction with the accompanying drawings of which:

FIG. 1 is a diagram schematically showing a configuration of an electronic shelf label system in accordance with an embodiment of the present invention;

FIG. 2 is a block diagram showing an electronic tag in accordance with another embodiment of the present invention;

FIG. 3 is a plan view showing an electronic paper panel in accordance with another embodiment of the present invention;

FIG. 4 is a cross-sectional view showing an electronic paper panel in accordance with another embodiment of the present invention; and

FIG. 5 is a flowchart showing a method for driving the electronic shelf label system in accordance with another embodiment of the present invention.

### DETAILED DESCRIPTION OF THE PREFERABLE EMBODIMENTS

Hereinafter, specific embodiments of the present invention will be described with reference to the drawings. The following embodiments merely illustrate the present invention, and the present invention is not limited to the following embodiments.

In describing the present invention, specific descriptions of well-known techniques are omitted so as not to unnecessarily obscure the embodiments of the present invention. The following terms are defined in consideration of functions of the present invention and may be changed according to users or operator's intentions or customs. Thus, the terms shall be defined based on the contents described throughout the specification.

The technical sprit of the present invention should be defined by the attached claims, and the following embodiments are provided as examples to efficiently convey the technical spirit of the invention to those skilled in the art.

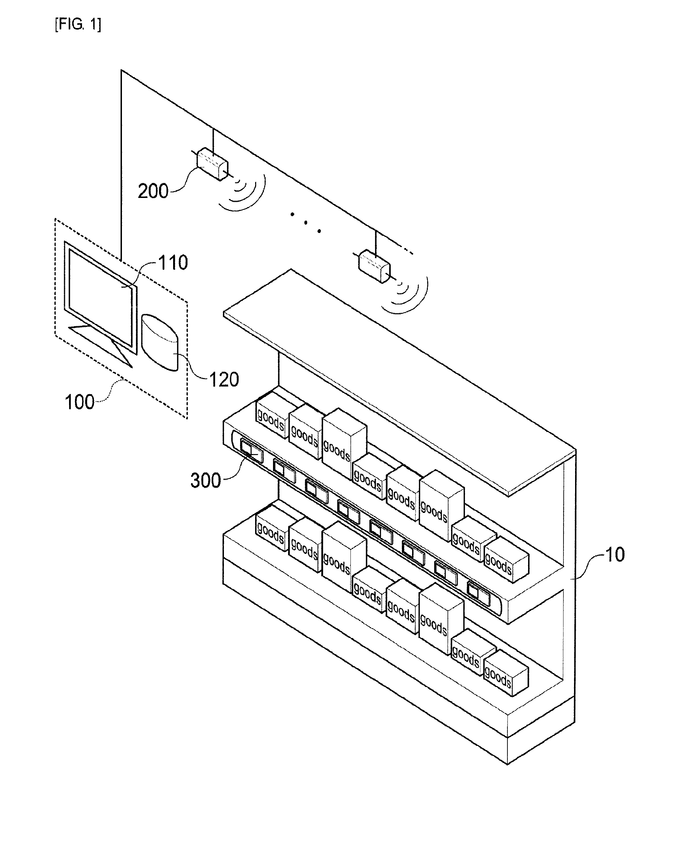

FIG. 1 is a diagram schematically showing a configuration of an electronic shelf label system in accordance with an embodiment of the present invention.

Referring to FIG. 1, the electronic shelf label system in accordance with an embodiment of the present invention includes a server 100, a wire/wireless communication converting unit 200 and an electronic tag 300.

Herein, each goods is displayed on the shelves of a display stand 10 and the electronic tag 300 to display the information of goods may be installed on the front surface of each shelf. Such electronic tag 300 displays basic information related to the goods such as a price, an expiration date and the date of manufacture of good. At this time, the basic information related to the goods may be received from the server 100 through the wire/wireless communication converting unit 200.

The server 100 includes an information processing unit 110 to receive or process the basic information related to the goods and a database unit 120 to store the basic information related to the goods. Herein, the server 100 generates a repair request signal when it receives a damage generation signal of the electronic tag 300; and, it informs a manager of a requested content by displaying the requested content on a screen or directly informs the manager by transmitting to a portable electronic device of the manager. At this time, the server 1000 may be formed of a computer.

The wire/wireless communication converting unit 200 receives the basic information related to the goods from the server 100 via wire and transmits the received basic information to the electronic tag 300 wirelessly. And also, it receives the basic information of the goods to be transmitted from the electronic tag 300 wirelessly or a damage generation signal and transmits it to the server 100 via wire.

As like this, the wire/wireless communication converting unit 200 is communicated with the server in a wire communication method and communicated with the electronic tags 300 in a wireless communication method.

That is, the wire/wireless communication converting unit 200 relays the basic information related to the goods or the damage generation signal or the like between the server 100 and the electronic tags 300 through the wire/wireless communication. At this time, the wire/wireless communication converting unit 200 may be installed plurals according to the size of a store and each of the wire/wireless communication converting units 200 is in charge of the relay of a predetermined number of electronic tags 300.

On the other hands, the wireless communication method capable of being applied to the electronic shelf label system may be ZigBee, RFID, IF, RF or various communication methods and it may be selected considering efficiency, cost or the like of the system configuration.

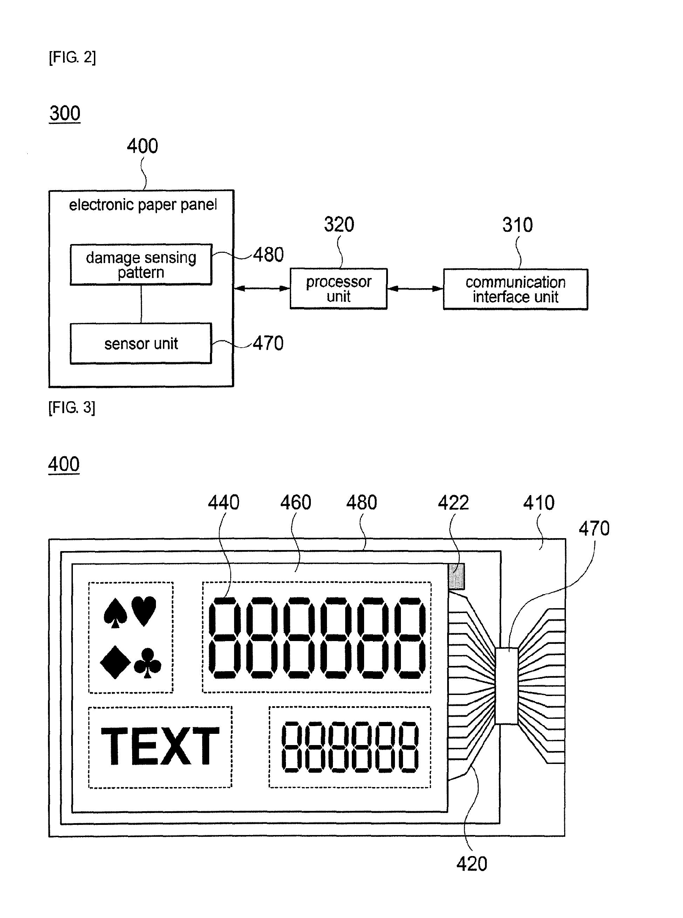

FIG. 2 is a block diagram showing an electronic tag in accordance with another embodiment of the present invention.

As shown in FIG. 2, the electronic tag 300 transmits the information related to the goods by displaying the basic information related to the goods received from the server 100 thorough the wire/wireless communication converting unit 200 and plays a role of promoting the sale of goods. In order to perform this function, the electronic tag 300 can include a communication interface unit 310, a processor unit 320 and an electronic paper panel 400.

The communication interface unit 310 can play roles of tranceiving the basic information related to the goods to/with the wire/wireless communication converting unit 200 or transceiving the damage generation signal to/with the wire/wireless communication converting unit 200 when the damage of the electronic tag 300 is sensed.

The processor unit 320 can transmit the basic information related to the goods received through the wire/wireless communication converting unit 200 and transmit the damage generation signal which is transmitted when the damage is sensed from the electronic paper panel 400 to the communication interface unit 310.

The electronic paper panel 400 can implement the basic information related to the goods transmitted from the processor unit 320 visually. At this time, in implementing the electronic paper panel 400, a segment display method, a dot matrix method or the like can be applied. In addition, the electronic paper panel 400 transmits the damage generation signal to the processor unit 320 by generating the damage generation signal when the damage is generated and transmit it to the server 100 through the communication interface unit 310.

The electronic paper panel 400 will be described in further detail as follows.

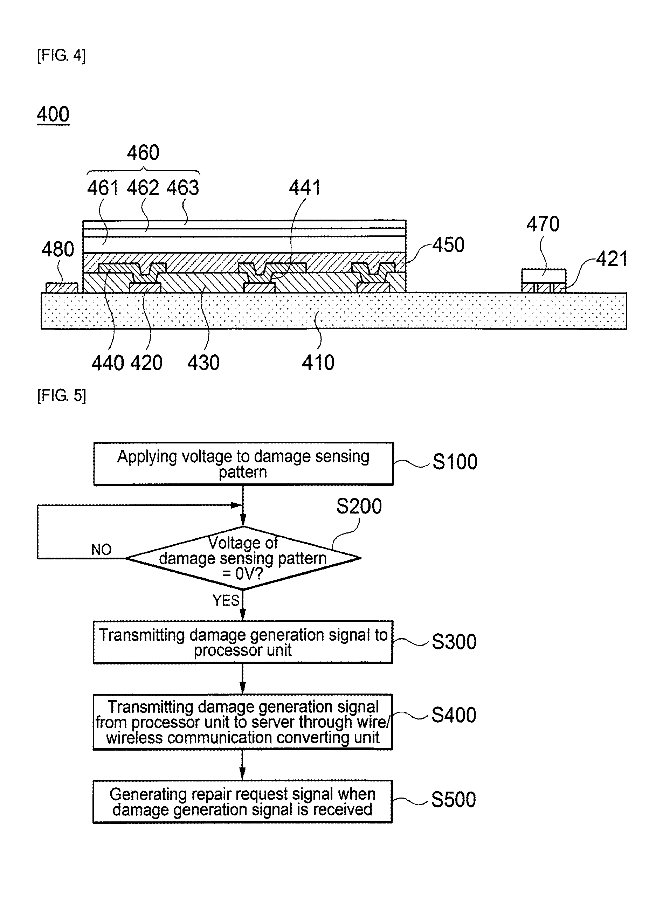

FIG. 3 is a plan view showing an electronic paper panel in accordance with another embodiment of the present invention; and FIG 4 is a cross-sectional view showing an electronic paper panel in accordance with another embodiment of the present invention.

As shown in FIG. 3 and FIG. 4, the electronic paper panel 400 includes a substrate 410, an insulating layer 430, a segment electrode 440, an electronic paper film 460 and a driving chip 470.

As the substrate 410 is to form a wiring patter 420 to be electrically connected with the electric paper film 460; it can be formed of a material such as a glass, a plastic, a ceramic or the like; and it is preferable that the substrate 410 is formed of the glass material.

Herein, the wiring pattern 420 can play a role of applying the driving signal applied from the driving chip 470 to the segment electrode 440 by electrically connecting the segment electrode 440 to be described hereinafter and the driving chip 470. At this time, the wiring pattern 420 may be formed of a conductive material, e.g., an ITO (Indium Tin Oxide).

And also, a pad unit 421 may be formed on the substrate 410 which is electrically connected to the wiring pattern 420 and on which the driving chip 470 is mounted.

The insulating layer 430 may be formed on the substrate 410 formed thereon the wiring pattern 420. Herein, the insulating layer 430 may be formed so as to insulated with the segment electrode 440 formed on the insulating layer 430. At this time, the insulating layer 430 may be formed of an insulating paste such as a glass paste, an insulating UV curable ink, a paste for a solder resist and the combination thereof.

The segment electrode 440 can display an image being arranged plural on the insulating layer 430. That is, the segment electrode 440 may be a minimum unit to display the image. Herein, the segment electrode 440 may be electrically connected to the wiring pattern 420 through a via 441 which penetrates the insulating layer 430.

The electronic paper film 460 is electrically connected to the segment electrode 440 and may be attached on the substrate 410 including the segment electrode 440.

Herein, the electronic paper film 460 can include an electronic paper layer 461, a common electrode 462 and a protection layer 463 which are sequentially stacked.

At this time, the electronic paper layer 461 can display the image by being driven by a voltage applied between the segment electrode 440 and the common electrode 462. Herein, an example of the electronic paper layer 461 may be in a type of an electrophoresis, a microcapsule, a twist ball or the like.

And also, the common electrode 462 may be formed of a transparent electrode, e.g., ITO. At this time, the common electrode 462 may receive a common voltage from an outside by being electrically connected to a common electrode pad 422.

Also, the protection layer 463 can play a role of protecting a surface of the electronic paper layer 461 from an outside thereof. At this time, the protection layer 463 may be formed of a transparent material. An example of the transparent material is a polyethylene terephthalate (PET), a polyvinyl alcohol (PVA), a polyethylene (PE), a polycarbonate (PC), a polyacrylate, a polymethylmethacrylate, a polyurethane, a cellulose acetate-butyl rate (CAB) or the like. However, in the embodiments of the present invention, the material of the protection layer 463 is not limited.

At this time, the electronic paper layer 461 and the segment electrode 440 may be electrically connected to each other through a conductive adhesive member 450 sandwiched therebetween. Herein, for example, the conductive adhesive member 450 may be an anisotropic conductive film (ACF), an anisotropic conductive paste (ACP) or the like.

The driving chip 470 may be mounted on the substrate 410.

Herein, the driving chip 470 may be electrically connected to the pad unit 421. At this time, the electrical connection between the driving chip 470 and the pad unit 421 may be implemented through a flip-chip bonding or a wire bonding. Therefore, the driving chip 470 may be electrically connected to the segment electrode 440 through the wiring pattern 420 arranged on a bottom of the insulating layer 430.

On the other hands, a damage sensing pattern 480 may be formed on the substrate 410.

Herein, the damage sensing pattern 480 may be formed along a peripheral of the substrate 410 and may be formed so as to apply a voltage from an outside thereof.

At this time, a sensor unit may be formed on one side of the damage sensing pattern 480 to sense the voltage applied to the damage sensing pattern 480. The sensor unit may be the driving chip 470 and may be additionally formed so as to be connected to the damage sensing pattern 480 on the substrate 410.

The sensor unit 470 senses the voltage applied to the damage sensing pattern 480; and, if the voltage of the damage sensing pattern 480 is not sensed, it can transmit the damage generation signal to the processor unit 300.

That is, the damage sensing pattern 480 is formed on the substrate 410; and, if the substrate 410 is damaged, since the voltage sensed from the sensor unit 470 drops from a high (High) to a low (Low) as the damaged portion of the damage sensing pattern 480 is shorted, the damage can be detected.

FIG 5 is a flowchart showing a method for driving the electronic shelf label system in accordance with another embodiment of the present invention.

As shown in FIG. 5, a method for driving an electronic shelf label system can perform a step S100 of applying a voltage to a damage sensing pattern 480 formed on a substrate 410 at first.

Thereafter, a step S200 of measuring the voltage applied from the sensor unit 470 to the damage sensing pattern 480 can be performed.

Herein, the sensor unit 470 can measure the voltage of the damage sensing pattern 480 continuously. At this time, according to the result of measurement, if the voltage drops to a low (Low), by generating the damage generation signal, a step S300 of transmitting the generated damage generation signal to a processor unit 320.

And then, a step S400 of transmitting the damage generation signal transmitted to the processor unit 320 to a server 100 through a wire/wireless communication converting unit 200.

Herein, the processor unit 320 transmits the damage generation signal to a communication interface unit 310 and the communication interface unit 310 transmits the damage generation signal to the wire/wireless communication converting unit 200 in a wireless communication method.

And, the wire/wireless communication converting unit 200 transmits the received damage generation signal to the server in a wire communication method.

Thereafter, the server 100 can perform a step S500 of generating a repair request signal by receiving the damage generation signal.

Herein, the server 100 informs a manager of the requested contents by displaying it on a screen when the repair request signal is generated or can inform the manager directly by transmitting the repair request signal to a portable electronic device of the manage.

Accordingly, the electronic paper panel, the electronic shelf label system and the method for driving the same in accordance with the embodiments of the present invention form the damage sensing pattern to apply the voltage to the electronic paper panel, determine the state whether the electronic paper panel is damaged by measuring the voltage applied to damage sensing pattern with the sensor unit, by transmitting it to the server, since it can identify whether the information of goods is displayed in the server normally or not, can prevent the information of goods such as the title of goods, a price of goods or the like from being wrongly displayed and can more effectively manage the electronic tags of the store.

Although the present invention has been described in detail with reference to the preferable embodiments, it will be appreciated by those skilled in the art that various modifications may be made in these embodiments without departing from the scope of the present invention.

Therefore, the scope of the present invention should not be limited by the described embodiments but defined by the appended claims and their equivalents.

## Claims

1. An electronic paper panel, comprising:
a substrate formed thereon a wiring pattern and a damage sensing pattern;
an insulating layer formed on the wiring pattern;
a segment electrode formed on the insulating layer and electrically connected to the wiring pattern; and
a driving chip mounted on the substrate.

2. The electronic paper panel according to claim 1, further comprising an electronic paper film formed on the segment electrode.

3. The electronic paper panel according to claim 2, wherein the electronic paper film includes:
an electronic paper layer;
a common electrode formed on the electronic paper layer; and
a protection layer formed on the common electrode.

4. The electronic paper panel according to claim 1, wherein a voltage is applied to the damage sensing pattern

5. The electronic paper panel according to claim 1, further comprising a sensing unit to sense the voltage to be applied by being electrically connected to the damage sensing pattern.

6. An electronic shelf label system, comprising:
an electronic tag installed on a display stand for transmitting a damage generation signal when an electronic paper panel is damaged;
a server for generating a repair request signal when the damage generation signal is generated; and
a wire/wireless communication converting unit for relaying information between the electronic tag and the server and for transmitting the damage generation signal received from the electronic tag which is in charge of the relay to the server.

7. The electronic shelf label system according to claim 6, wherein the electronic tag includes:
an electronic paper panel provided with a damage sensing pattern and a sensor unit for sensing a voltage of the damage sensing pattern; and
a processor unit for transmitting the damage generation signal to a wire/wireless communication converting unit according to the sensing result of a sensor unit.

8. The electronic shelf label system according to claim 6, wherein the sensor unit senses the voltage of the damage sensing pattern formed on the electronic paper panel and transmitting the damage generation signal to the processor unit if the voltage is not sensed.

9. A method for driving an electronic shelf label system, comprising:
inspecting a damage of an electronic tag including a damage sensing pattern, a sensor unit and a processor unit and generating a damage generating signal when the damage is generated;
transmitting the generated damage generation signal to a wire/wireless communication converting unit;
delivering the damage generation signal received from the wire/wireless communication converting unit to a server; and
generating a repair request signal when the damage generation signal is received to the server.

10. The method for driving an electronic shelf label system according to claim 9, wherein transmitting the damage generation signal when the damage of the electronic tag including the damage sensing pattern, a sensor unit and a processor unit is generated includes:
applying a voltage to the damage sensing pattern; and
measuring the voltage applied to the damage sensing pattern with the sensor unit and transmitting the damage generation signal to the processor unit if the voltage is not measured.

11. The method for driving an electronic shelf label system according to claim 9, wherein, in transmitting the generated damage generation signal to a wire/wireless communication converting unit, the damage generation signal is transmitted to the wire/wireless communication converting unit from a processor unit of the electronic tag.
